(19) Europäisches Patentamt

European Patent Office

Office européen des brevets

(11) **EP 0 527 530 B1**

(12) **EUROPÄISCHE PATENTSCHRIFT**

(45) Veröffentlichungstag und Bekanntmachung des Hinweises auf die Patenterteilung:
**15.01.1997 Patentblatt 1997/03**

(51) Int Cl.6: **G01R 33/28**, G01R 33/54

(21) Anmeldenummer: **92202377.5**

(22) Anmeldetag: **31.07.1992**

(54) **Kernresonanz-Untersuchungsgerät mit einer Spulenanordnung**

Nuclear resonance examining apparatus with a coil arrangement

Appareil d'examen à résonance nucléaire comportant un agencement de bobines

(84) Benannte Vertragsstaaten:
**DE FR GB**

(30) Priorität: **10.08.1991 DE 4126537**

(43) Veröffentlichungstag der Anmeldung:
**17.02.1993 Patentblatt 1993/07**

(73) Patentinhaber:
- **Philips Patentverwaltung GmbH**
  **22335 Hamburg (DE)**
  Benannte Vertragsstaaten:
  **DE**
- **Philips Electronics N.V.**
  **5621 BA Eindhoven (NL)**
  Benannte Vertragsstaaten:
  **FR GB**

(72) Erfinder: **Leussler, Christoph Günther**
**W-2000 Hamburg 1 (DE)**

(74) Vertreter: **Hartmann, Heinrich, Dipl.-Ing. et al**
**Philips Patentverwaltung GmbH,**
**Röntgenstrasse 24**
**22335 Hamburg (DE)**

(56) Entgegenhaltungen:
**EP-A- 0 173 130        EP-A- 0 368 401**
**JP-A- 1 223 943        US-A- 4 737 712**
**US-A- 4 740 744**

- **PATENT ABSTRACTS OF JAPAN vol. 10, no. 358 (P-522)(2415) 2. Dezember 1986 & JP-A- 61 155 846**
- **SOCIETY OF MAGNETIC RESONANCE IN MEDICINE , SEVENTH ANNUAL MEETING AND EXHIBITION Bd. 2, 20. August 1988, SAN FRANCISCO, CA, (US) Seite 860 W.S. YAMANASHI ET AL. 'PRELIMINARY STUDY ON THE USE OF FIBEROPTICS IN THE COIL TO RECEIVER LINKAGE'**

**Beschreibung**

Die Erfindung betrifft ein Kernresonanz-Untersuchungsgerät mit einer Spulenanordnung zum Empfangen von in einem Untersuchungsbereich erzeugten Kernresonanzsignalen und einer Auswerteeinheit zum Verarbeiten der in der Spulenanordnung empfangenen Signale.

Derartige Geräte sind bekannt, beispielsweise aus der EP-OS 226 247. Bei solchen Geräten befindet sich die Spulenanordnung bei einer Untersuchung am Körper eines Patienten, während die Auswerteeinheit, die eine Rekonstruktionseinheit zur Rekonstruktion der Kernmagnetisierungsverteilung im Untersuchungsbereich umfassen kann sowie ein Sichtgerät zur bildlichen Darstellung dieser Verteilung, einige Meter davon entfernt angeordnet ist. Bei den bekannten Geräten dieser Art ist die Spulenanordnung über ein Kabel mit der Auswerteeinheit verbunden. Die Kabelverluste können das Signal-Rausch-Verhältnis verschlechtern. Darüberhinaus können durch unvermeidliche Unsymmetrien Mantelwellen auftreten, die die Spulenanordnung verstimmen und im Gewebe des Patienten zusätzliche Hochfrequenzverluste verursachen.

Es sind jedoch Kernresonanzuntersuchungsgeräte bekannt, bei denen die Kernresonanzsignale über ein optisches Kabel von der Spulenanordnung zur Auswerteeinheit übertragen werden ; siehe z.B. Patent Abstract of Japan, vol. 10, no. 358 (p-522)[2415], 2. Dez. 1986 & JP-A-61 155846 oder JP-A- 1 223 943.

Es ist Aufgabe der vorliegenden Erfindung, ein Kernresonanz-Untersuchungsgerät der eingangs genannten Art so auszugestalten, daß die geschilderten Effekte nicht wirksam werden können. Diese Aufgabe wird erfindungsgemäß durch die im Anspruch 1 angegebenen Maßnahmen gelöst.

Bei der Erfindung wird das Kernresonanzsignal von der Spulenanordnung zu der entfernt davon angeordneten Auswerteeinheit drahtlos übertragen, so daß die mit einer Kabelverbindung einhergehenden Effekte entfallen. Der Frequenzumsetzer verhindert dabei, daß die elektromagnetischen Wellen, die von der im Sender enthaltenen Antenne abgestrahlt werden, von der auf die im Untersuchungsbereich herrschende Larmorfrequenz abgestimmten Spulenanordnung empfangen werden können.

In weiterer Ausgestaltung der Erfindung ist vorgesehen, daß der Frequenzumsetzer eine Mischstufe enthält, in der das Kernresonanzsignal mit einem Mischsignal mit konstanter Frequenz gemischt wird.

Die Anforderungen an die Frequenz- und Phasenkonstanz des Hilfssignals sind dabei genauso hoch wie die Anforderungen, die an einen Oszillator gestellt werden müssen, der in der Auswerteeinheit Signale mit Larmorfrequenz erzeugt.

Ein derartiger Oszillator wäre verhältnismäßig teuer und voluminös und würde - da sich die Frequenzstabilisierung in der Regel nur durch eine Temperaturregelung des Oszillators erreichen läßt - die Versorgungsspannungsquelle zur Versorgung des bei der Untersuchungsspule befindlichen Senders - zweckmäßigerweise eine (vorzugsweise wiederaufladbare) Batterie - erheblich belasten.

Eine Weiterbildung der Erfindung sieht daher vor, daß in unmittelbarer Nähe der Spulenanordnung ein Empfänger zum Empfang des drahtlos übertragenen Hilfssignals vorgesehen ist und daß aus diesem Signal das Mischsignal abgeleitet wird, mit dem das Kernresonanzsignal in dem Mischer gemischt wird. Der Platz- und Energiebedarf läßt sich kleinhalten, insbesondere wenn mit verhältnismäßig hohen Frequenzen gearbeitet wird und Schaltungsbausteine verwendet werden, die in integrierter Schaltungstechnik vorliegen.

Die Ableitung des Mischsignals aus dem Hilfssignal erfolgt zweckmäßigerweise dadurch, daß das Mischsignal von einem Oszillator erzeugt wird, der durch das Hilfssignal synchronisiert wird. Dieser in unmittelbarer Nähe der Spulenanordnung befindliche Oszillator muß keine hohen Anforderungen hinsichtlich Frequenz- und Phasenstabilität erfüllen, weil er durch das Hilfssignal synchronisiert wird.

In weiterer Ausgestaltung der Erfindung ist vorgesehen, daß die Frequenz des Hochfrequenzerzeugers und des Hilfssignals aus einer gemeinsamen Referenzsignalquelle abgeleitet werden. Da hierbei die Frequenz des Hilfssignals ebenso wie die Larmorfrequenz, mit der die Hochfrequenzsendespule beaufschlagt wird, von einem gemeinsamen Referenzoszillator abgeleitet werden, läßt sich der Aufwand gering halten, und die beiden Frequenzen sind starr miteinander verknüpft.

Es ist praktisch nicht möglich, den bei der Spulenanordnung befindlichen Sender mit einer Versorgungsspannung zu speisen, die aus mit einem Netzteil abgeleitet wird, weil auch ein solches Netzteil ein Kabel zum Anschluß an eine Versorgungsspannungsquelle benötigen würde. Wenn die Versorgungsspannung für den Sender auf andere Weise erzeugt wird, beispielsweise mittels einer Batterie- oder Akkumulatoranordnung, dann ist es wichtig, den Energieverbrauch möglichst kleinzuhalten. Dies wird nach einer Weiterbildung der Erfindung dadurch erreicht, daß die Versorgungsspannung für wenigstens einen Teil des Senders über einen steuerbaren Schalter zugeführt wird, der nach einem Hochfrequenzimpuls im Untersuchungsbereich für eine definierte Zeit geschlossen bleibt. Die Versorgungsspannung wird dabei in einer definierten Zeit nach dem letzten im Untersuchungsbereich erzeugten Hochfrequenzimpuls abgeschaltet.

Die Erfindung wird nachstehend anhand der Zeichnung näher erläutert. Es zeigen

Fig. 1 ein Kernresonanz-Untersuchungsgerät, bei dem die Erfindung anwendbar ist, in schematischer Darstellung;

Fig. 2 ein Blockschaltbild eines solchen Gerätes und

Fig. 3 das Blockschaltbild einer Einheit zum Ein- und Ausschalten der Versorgungsspannung für den Sender.

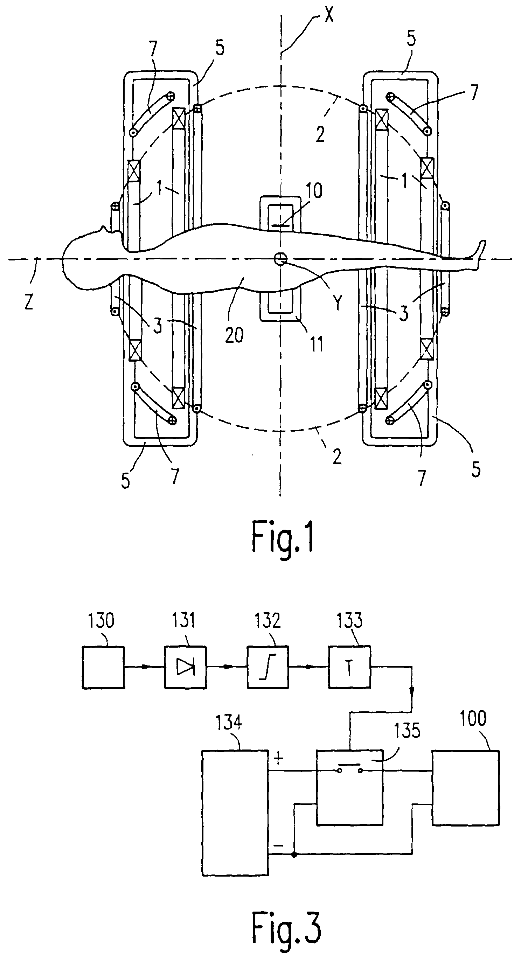

Das in Fig. 1 schematisch dargestellte Kernresonanz-Untersuchungsgerät enthält eine aus vier Spulen 1 bestehende Anordnung zur Erzeugung eines homogenen stationären und in z-Richtung verlaufenden Magnetfeldes. Die zur z-Achse konzentrisch angeordneten Spulen können auf einer Kugeloberfläche 2 angeordnet sein. Im Innern dieser Spulen befindet sich der zu untersuchende Patient 20. Weiterhin ist eine Hochfrequenz-Sendespule 11 vorgesehen, die so ausgebildet ist, daß damit ein im wesentlichen homogenes senkrecht zur z-Richtung verlaufendes hochfrequentes Magnetfeld erzeugt werden kann. Die Frequenz dieses hochfrequenten Magnetfeldes muß der Larmorfrequenz $f_o$ entsprechen, für die die Beziehung gilt:

$$f_o = cB.$$

Dabei ist B die magnetische Induktion des homogenen stationären Magnetfeldes und c die gyromagnetische Konstante, die für Wasserstoffprotonen etwa 42,58 MHz/T beträgt. Die Sendespule 10 ist fest im Gerät eingebaut und über ein nicht näher dargestelltes Kabel an einen Hochfrequenzerzeuger angeschlossen, der Hochfrequenzimpulse erzeugt, deren Amplitude und Dauer so bemessen ist, daß dadurch die Kernmagnetisierung aus der z-Richtung vorzugsweise in eine dazu senkrechte Ebene gekippt wird.

Die durch die Hochfrequenzimpulse bewirkte Anregung der Kernmagnetisierung hat in dem von der Hochfrequenzspule beeinflußten Untersuchungsbereich das Entstehen von Kernresonanzsignalen zur Folge, die von der Kernmagnetisierungsverteilung abhängig sind. Diese Kernresonanzsignale werden mit einer Spulenanordnung 10 nachgewiesen, beispielsweise einer Oberflächenspule, die auf einem flexiblen oder steifen Träger angeordnet ist Das in dieser Spulenanordnung, die auf die Larmorfrequenz $f_o$ abgestammt ist, induzierte Signal wird einer in Fig. 1 nicht dargestellten Auswerteeinheit zugeführt, die daraus die räumliche oder spektrale Verteilung der Kernmagnetisierung bestimmt.

Außerdem sind aus jeweils mehreren Spulen 3, 5 und 7 bestehende Gradientenspulenanordnungen vorgesehen, mit denen ein in z-Richtung verlaufendes Magnetfeld mit einem Gradienten in x-, y- oder z-Richtung erzeugt werden kann. Diese Spulen werden während der Erzeugung des Hochfrequenzimpulses, beim Auftreten des Kernresonanzsignales oder dazwischen von einem Strom durchflossen, worauf eine räumliche Zuordnung der Kernmagnetisierungsverteilung abgeleitet werden kann.

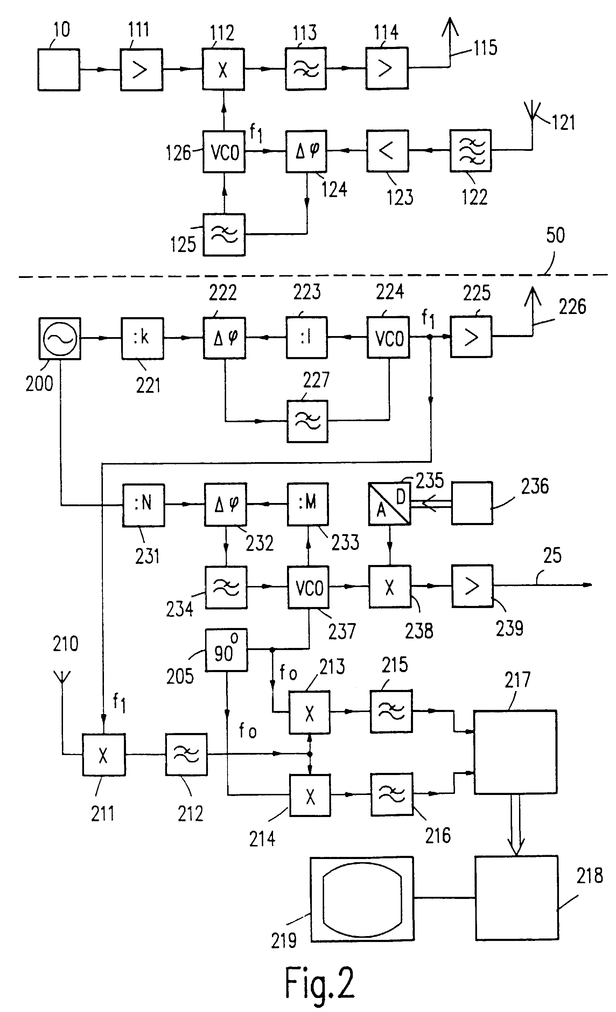

Wie sich aus Fig. 2 ergibt, wird das in der Spule 10 induzierte Kernresonanzsignal von einem rauscharmen Verstärker 111 verstärkt und über einen Frequenzumsetzer 112, 113 und einen weiteren Verstärker 114 einer Antenne 115 zugeführt und von dieser abgestrahlt. Da der Empfänger für dieses Antennensignal sich nur wenige Meter entfernt am Orte der Auswerteeinheit befindet, kann die Sendeleistung relativ gering sein. Die Verstärkung des Verstärkers 111 muß ausreichend sein, um zu verhindern, daß das Signal-Rausch-Verhältnis sich durch die Frequenzumsetzung und die Übertragung verschlechtert.

Der Frequenzumsetzer umfaßt eine Mischstufe 112, in der das Kernresonanzsignal mit einem Mischsignal mit konstanter Frequenz $f_1$ gemischt wird. Die Mischstufe 112, vorzugsweise eine Halbleiterschaltung, liefert an ihrem Ausgang ein Signal, das dem Produkt der Signale an den Eingängen der Mischstufe proportional ist. Somit enthält das Ausgangssignal Komponenten mit der Differenzfrequenz $/f_1\text{-}f_o/$ oder mit der Summenfrequenz $f_1\text{+}f_o$. Das Filter 113 unterdrückt die Differenzfrequenzkomponente und läßt nur die Komponente mit der Summenfrequenz durch. Es kann sich dabei um einen auf die Summenfrequenz abgestimmten Bandpaß oder um einen geeigneten Hochpaß handeln

Die Frequenz $f_1$ des Mischsignals ist so gewählt (einige MHz bis einige 100 MHz) daß die Summenfrequenz $f_1 + f_o$ genügend hoch ist, um eine drahtlose Übertragung mit geringem Antennenaufwand zu gestatten. Insbesondere ist die Frequenz $f_1$ so gewählt, daß die Summenfrequenz oder deren Harmonische nicht mit Harmonischen der Frequenzen $f_1$ bzw. $f_o$ zusammenfällt

Grundsätzlich könnte das Mischsignal von einem frequenz- und phasenstabilisierten Oszillator geliefert werden. Dieser müßte sich in unmittelbarer Nähe der Schaltungskomponenten 111..114 befinden und sehr strengen Bedingungen hinsichtlich Frequenz- und Phasenstabilität genügen. Derartige Oszillatoren sind z.Zt. noch verhältnismäßig voluminös und teuer und verbrauchen für ihre Temperaturstabilisierung relativ viel Energie. Deshalb wird die Frequenz des Mischsignals aus einem drahtlos übertragenen Hilfssignal abgeleitet, das die vorgeschriebenen Bedingungen an Frequenz- und Phasenstabilität erfüllt.

Zu diesem Zweck ist eine zusätzliche Antenne 121 vorgesehen (wenn die Antenne 115 genügend breitbandig wäre, könnte auch diese verwendet werden). Das Antennensignal wird über einen auf die Frequenz des Hilfssignals abgestimmten Bandpaß 122 einem Verstärker 123 zugeführt. Wenn das Hilfssignal die gewünschte Frequenz $f_1$ hätte und ohne Amplitudenschwankungen zu empfangen wäre, könnte es vom Verstärker 123 unmittelbar der Mischstufe 112 zugeführt werden.

Im vorliegenden Fall wird das Mischsignal jedoch von einem in der Frequenz steuerbaren Oszillator 126 erzeugt, der durch das Referenzsignal synchronisiert wird. Zu diesem Zweck wird das vom Oszillator erzeugte Mischsignal nicht nur der Mischstufe 112 zugeführt, sondern - erforderlichenfalls über einen Frequenzteiler - einem Eingang eines Phasendiskriminators 124. Der zweite Eingang des Phasendiskriminators 124 ist - gegebenenfalls über einen Frequenzteiler - mit dem Ausgang des Verstärkers 123 verbunden. Der Phasendiskriminator erzeugt ein von der Phasenabweichung abhängiges Signal. Dieses wird über einen Tiefpaß 125 dem Steuereingang des Oszillators 126 zugeführt, dessen Frequenz und Phase durch den von den Elementen 124..126 gebildeten Phasenregelkreis variiert wird, bis die den Eingängen des Phasendiskriminators zugeführten Signale hinsichtlich Frequenz und Phase identisch sind. Die Komponenten 111..126 sind in unmittelbarer Nähe der Spulenanordnung 10 angeordnet, beispielsweise auf den zuvor erwähnten Träger, auf dem die Spule 10 angebracht ist. Gegebenenfalls kann auch eine Steckverbindung vorgesehen sein, über den die auf einem geeigneten Substrat angebrachten Komponenten 111..126 lösbar mit der Spule verbunden werden, so daß diese Einheit auch für andere spulen eingesetzt werden kann.

Werden zum Empfang von Kernresonanzsignalen aus unterschiedlichen Körperabschnitten sogenannte Arrayspulen eingesetzt, die voneinander unabhängige Kernresonanzsignale liefern, dann müssen diese auf unterschiedliche Frequenzen umgesetzt werden. Mit Ausnahme der Komponenten 121..123 müßten dann alle Komponenten entsprechend oft vorhanden sein, und die unterschiedlichen Frequenzen für die Mischsignale könnten dadurch erzeugt werden, daß zwischen dem Verstärker 123 und dem Phasendiskriminator 124 Frequenzteiler mit unterschiedlichem Frequenzteilerverhältnis angeordnet werden.

Wie durch die gestrichelte Linie 50 in Fig. 2 symbolisch angedeutet, befindet sich die Einheit mit den Komponenten 10..126 räumlich in einigen Metern Entfernung von der Auswerteeinheit, die unterhalb der Linie 50 dargestellt ist. Sie umfaßt eine Antenne 210, die das von der Antenne 115 abgestrahlte Signal aufnimmt und - gegebenenfalls über einen Vorverstärker - einem Eingang einer ersten Mischstufe 211 zuführt. Dem anderen Eingang dieser Mischstufe wird ein Signal mit der Frequenz $f_1$ zugeführt, so daß am Ausgang der Mischstufe 211 ein Signal entsteht, das eine Signalkomponente bei der Frequenz $2f_1 + f_o$ aufweist und eine Signalkomponente bei der Frequenz $f_o$. Mittels eines Filters 212, das entweder als Bandpaß ausgebildet ist, der nur die Frequenz $f_o$ durchläßt oder als Tiefpaß, der die Komponente $2f_1 + f_o$ unterdrückt, wird die Signalkomponente um die Larmorfrequenz $f_o$ herum ausgefiltert und je einem Eingang zweier identischer Mischstufen 213 und 214 zugeführt.

Dem jeweils anderen Eingang dieser Mischstufen wird ein Mischsignal mit der Frequenz $f_o$ direkt (Mischstufe 213) bzw. über ein 90°-Phasendrehglied 205 (Mischstufe 214) zugeführt. Den Mischstufen 213 und 214 ist je ein Tiefpaß 215 bzw. 216 nachgeschaltet, der die höheren Frequenzkomponenten unterdrückt. Die Komponenten 205 und 213..216 bilden somit einen Quadraturdemodulator, dessen niederfrequente analoge Ausgangssiggnale die Information über die Kernmagnetisierung innerhalb des Untersuchungsbereichs enthalten. Diese Signale werden einer Einheit 217 zugeführt, wo sie in digitale Datenworte umgesetzt und gespeichert werden. Aus den gespeicherten Werten wird mittels einer Rechtskonstruktionseinheit 218 die spektrale und/oder räumliche Verteilung der Kernmagnetisierung im Untersuchungsbereich ermittelt und auf einem geeigneten Monitor 219 oder dergl. ausgegeben.

Grundsätzlich wäre es möglich, die Signale mit den Frequenzen $f_1$ und $f_o$ unterschiedlichen Schwingungserzeugern zu entnehmen. Diese müßten jedoch jeder für sich die strengen Anforderungen an die Frequenz- und Phasenkonstanz erfüllen. Bei der in Fig. 2 dargestellten Anordnung wird ein anderer Weg gegangen, indem die Frequenzen von einem gemeinsamen Referenzoszillator 200 abgeleitet werden. Dieser kann so ausgestaltet sein, daß er in einem vorgebbaren Temperaturbereich und in einem vorgebbaren Versorgungsspannungsbereich die erforderliche Frequenz- und Phasenstabilität aufweist Dieser Referenzoszillator ist über einen Frequenzteiler 221 mit dem einen Eingang eines Phasendiskriminators 222 verbunden, dessen anderer Eingang über einen Frequenzteiler 223 mit einem in der Frequenz steuerbaren Oszillator 224 verbunden ist. Für die Frequenz $f_r$ des Referenzoszillators muß dabei die Beziehung gelten:

$$f_r = k/l\, f_1,$$

wobei k und l die ganzzahligen Frequenzteilerfaktoren der Frequenzteiler 221 bzw. 223 sind. Der Ausgang des Phasendiskriminators ist über einen Tiefpaß 227 mit dem Steuereingang des Oszillators 224 verbunden, so daß die Frequenz- und Phasenkonstanz des von dem Oszillator 224 gelieferten Signals durch den Differenzoszillator 200 bestimmt wird.

Das Ausgangssignal des Oszillators 224 wird einerseits als Mischsignal einem Eingang der Mischstufe 211 und andererseits einem Verstärker 225 zugeführt, an den eine Antenne 226 angeschlossen ist, die mit der Antenne 121 im Sender zusammenwirkt.

Die vom Referenzoszillator 200 erzeugten Signale werden auch dazu benutzt, mittels der Frequenzteiler 231 und 233, des Phasendiskriminators 232 und des Tiefpasses 234 einen Oszillator 237 zu synchronisieren, der ein Signal mit der Frequenz $f_o$ hervorruft. Dieses Signal wird in einer Modulationsstufe 238 mit einem der Hüllkurve des mit der Hochfrequenzsendespule zu erzeugenden Hochfrequenzimpulsens entsprechenden Hüllkurvensignal moduliert, das einem Hüllkurvensignal-Speicher 236 entnommen wird, der mit einem Modulationseingang der Modulationsstufe 238 über einen Digital-Analog-Wandler 235 gekoppelt ist. Das auf die Trägerfrequenz $f_o$ modulierte Signal wird von einem Verstärker 239 verstärkt und über ein fest verlegtes Kabel 225 der Hochfrequenzspule 11 zugeführt.

Die in der Frequenz steuerbaren Oszillatoren 126, 224 und 237 sind vorzugsweise Quarzoszillatoren. Die Frequenz eines Quarzoszillators kann beispielsweise mit einer Kapazitätsdiode gesteuert werden, die in bezug auf den Quarz in gleicher Weise geschaltet ist, wie sonst die sogenannten Ziehkondensatoren geschaltet werden, also beispielse in Serie zum Schwingquarz. Ein solcher Oszillator hat zwar nur einen relativ kleinen Verstimmungsbereich, aber schon eine gewisse Frequenz- und Phasenstabilität.

Die Versorgungsspannung für die in Fig. 2 dargestellten Komponenten 111..126 kann einer oder mehreren Batterien entnommen werden, die gegebenenfalls wiederaufladbar sind (Akkumulatoren). Ein - verhältnismäßig voluminöses -Netzteil in der Nähe dieser Komponenten könnte nämlich Störsignale hervorrufen. Bei einer Versorgungsspannungsbatterie ist aber ein geringer Energieverbrauch der dadurch gespeisten Schaltung wesentlich.

Gemäß Fig. 3 wird dieser geringe Energieverbrauch dadurch erreicht, daß die Versorgungsspannung für die Komponenten 111..126, die in Fig. 3 in dem Schaltungsblock 100 enthalten sind, über einen mit der Versorgungsspannungsquelle 134 verbundenen gesteuerten Schalter 135 zugeführt. Dieser wird von einem Zeitglied 133 immer dann geschlossen, wenn im Untersuchungsbereich durch die Spule 11 Hochfrequenzimpulse erzeugt werden. Diese lassen sich mittels einer Pickup-Spule 130, die mit der Hochfrequenzspule 11 magnetisch gekoppelt ist, nachweisen. Die Kopplung muß dabei lose sein, damit dem von der Spule 11 erzeugten Hochfrequenzfeld nicht zuviel Energie entnommen wird und das Hochfrequenzfeld unverzerrt bleibt. Der Pickup-Spule 130 ist ein Gleichrichter 131 nachgeschaltet, dessen Ausgangssignal einen Komparator 32 steuert, der das Zeitglied 133 schaltet. Nach jedem Hochfrequenzimpuls übersteigt die Ausgangsspannung des Gleichrichters 131 eine Schwellen spannung im Komparator 132, so daß das Zeitglied 133 aktiviert wird. Dieses bleibt in dem aktivierten Zustand für einen Zeitraum, der größer ist als der zeitliche Abstand zweier Hochfrequenzimpulse bei einer Kernresonanzuntersuchung; die Aktivierungsdauer kann im Sekunden- oder gar im Minutenbereich liegen. Wenn nach einem Hochfrequenzimpuls die durch das Zeitglied 133 vorgegebene Zeit verstrichen ist, ohne daß ein neuer Hochfrequenzimpuls auftritt, öffnet das Zeitglied 133 den Schalter 135. Die Komponenten 131..135 bleiben ständig an die Versorgungsspannung angeschlossen.

- Wenn der Energieverbrauch der Komponenten 111..126 Klein genug ist, kann die Energieversorgungsspannung auch unmittelbar aus den Hochfrequenzimpulsen entnommen werden. Da die Hochfrequenzimpulse für die Spule 11 eine Leistung von einigen 100 W bis zu einem kW aufweisen, kann eine Energie von einigen 1/10 W oder weniger dem hochfrequenten Magnetfeld ohne Störungen entnommen werden.

## Patentansprüche

1. Kernresonanz-Untersuchungsgerät mit einer Spulenanordnung (10) zum Empfangen von in einem Untersuchungsbereich erzeugten Kernresonanzsignalen und einer Auswerteeinheit zum Verarbeiten der in der Spulenanordnung empfangenen Signale, dadurch gekennzeichnet, daß in unmittelbarer Nähe der Spulenanordnung (10) ein Sender zur Übertragung der Kernresonanzsignale vorgesehen ist, der einen Frequenzumsetzer enthält, daß an einen Empfänger (211, 212) eine Auswerteeinheit (213 ... 219) angeschlossen ist, daß der Sender und der Empfänger über je eine Antenne (115, 210) zusammenwirken und daß die Energieversorgung für den Sender aus einem in dem Kernresonanzuntersuchungsgerät auftretenden hochfrequenten Magnetfeld entnommen wird.

2. Kernresonanz-Untersuchungsgerät nach Anspruch 1, dadurch gekennzeichnet, daß der Frequenzumsetzer eine Mischstufe (112) enthält, in der das Kernresonanzsignal mit einem Mischsignal mit konstanter Frequenz ($f_1$) gemischt wird.

3. Kernresonanz-Untersuchungsgerät nach Anspruch 2, dadurch gekennzeichnet, daß in unmittelbarer Nähe der Spulenanordnung ein Empfänger (121.. 123) zum Empfang eines drahtlos übertragenen Hilfssignals vorgesehen ist und daß aus diesem Signal das Mischsignal abgeleitet wird, mit dem das Kernresonanzsignal in dem Mischer gemischt wird.

4. Kernresonanz-Untersuchungsgerät nach Anspruch 3, dadurch gekennzeichnet, daß das Mischsignal von einem Oszillator (126) erzeugt wird, der durch das Hilfssignal synchronisiert wird.

5. Kernresonanz-Untersuchungsgerät nach Anspruch 3 mit einem Hochfrequenzerzeuger (237..239), der eine Spulenanordnung (11) zur Erzeugung eines Hochfrequenzmagnetfeldes im Untersuchungsbereich beaufschlagt, dadurch gekennzeichnet, daß die Frequenz des Hochfrequenzerzeugers ($f_o$) und des Hilfssignals ($f_1$) aus einer gemeinsamen Referenzsignalquelle (200) abgeleitet werden.

6. Kernresonanz-Untersuchungsgerät nach Anspruch 1, dadurch gekennzeichnet, daß die Versorgungsspannung für wenigstens einen Teil des Senders über einen steuerbaren Schalter (134) zugeführt wird, der nach einem Hochfrequenzimpuls im Untersuchungsbereich für eine definierte Zeit geschlossen leibt.

## Claims

1. A magnetic resonance examination apparatus, comprising a coil system (10) for receiving magnetic resonance signals generated in an examination zone and a processing unit for processing the signals received in the coil system, characterized in that in the direct vicinity of the coil system (10) there is arranged a transmitter for the transmission of the magnetic resonance signals which includes a frequency converter, that a processing unit (213...219) is connected to a receiver (211, 212), that the transmitter and the receiver cooperate via a respective antenna (115, 210), and that the energy supply for the transmitter is derived from a high-frequency magnetic field occurring in the magnetic resonance examination apparatus.

2. A magnetic resonance examination apparatus as claimed in Claim 1, characterized in that the frequency converter comprises a mixing stage (112) in which the magnetic resonance signal is mixed with a mixing signal of constant frequency ($f_1$).

3. A magnetic resonance examination apparatus as claimed in Claim 2, characterized in that in the direct vicinity of the coil system there is arranged a receiver (121...123) for receiving a wireless transmitted auxiliary signal, the mixing signal with which the magnetic resonance signal is mixed in the mixer being derived from said auxiliary signal .

4. A magnetic resonance examination apparatus as claimed in Claim 3, characterized in that the mixing signal is generated by an oscillator (126) which is synchronized by the auxiliary signal.

5. A magnetic resonance examination apparatus as claimed in Claim 3, comprising an high-frequency generator (237...239) which acts on a coil system (11) for generating an high-frequency magnetic field in the examination zone, characterized in that the frequency of the high-frequency generator ($f_o$) and of the auxiliary signal ($f_1$) are derived from a common reference signal source (200).

6. A magnetic resonance examination apparatus as claimed in Claim 1, characterized in that the supply voltage for at least a part of the transmitter is supplied via a controllable switch (134) which remains closed for a defined period of time subsequent to a high-frequency pulse in the examination zone.

## Revendications

1. Appareil d'examen à résonance magnétique nucléaire avec un agencement de bobines (10) pour la réception de signaux de résonance magnétique nucléaire produits dans une région à examiner et d'une unité d'analyse pour le traitement des signaux reçus dans l'agencement de bobines, caractérisé en ce qu'à proximité directe de l'agencement de bobines (10) est prévu un émetteur pour la transmission des signaux de résonance magnétique nucléaire qui contient un convertisseur de fréquence, qu'une unité d'analyse (213...219) est raccordée à un récepteur (211,212), que l'émetteur et le récepteur coopèrent par l'intermédiaire d'une antenne (115, 210) respective et que l'alimentation en énergie pour l'émetteur est prélevée à partir d'un champ magnétique à haute fréquence généré dans l'appareil d'examen à résonance magnétique nucléaire.

2. Appareil d'examen à résonance magnétique nucléaire selon la revendication 1, caractérisé en ce que le convertisseur de fréquence contient un étage mélangeur (112) dans lequel un signal de résonance magnétique nucléaire est mélangé à un signal mélangeur de fréquence constante ($f_1$).

3. Appareil d'examen à résonance magnétique nucléaire selon la revendication 2, caractérisé en ce qu'à proximité directe de l'agencement de bobines est prévu un récepteur (121...123) pour la réception d'un signal auxiliaire transmis sans fil et qu'à partir de ce signal est dérivé le signal mélangeur avec lequel le signal de résonance magnétique nucléaire est mélangé dans le mélangeur.

4. Appareil d'examen à résonance magnétique nucléaire selon la revendication 3, caractérisé en ce que le signal mélangeur est produit par un oscillateur (126) qui est synchronisé par le signal auxiliaire.

5. Appareil d'examen à résonance magnétique nucléaire selon la revendication 3 avec un générateur de hautes fréquences (237...239) qui alimente un agencement de bobines (11) pour la production d'un champ magnétique à haute fréquence dans la région à examiner, caractérisé en ce que les fréquences du générateur de hautes fréquences ($f_o$) et du signal auxiliaire ($f_1$) sont dérivées d'une source de signal de référence (200) commune.

6. Appareil d'examen à résonance magnétique nucléaire selon la revendication 1, caractérisé en ce que la tension d'alimentation est amenée pour au moins une partie de l'émetteur par l'intermédiaire d'un interrupteur commandable (134) qui reste fermé après une impulsion à haute fréquence dans la région à examiner pendant une période définie.

Fig.1

Fig.3

Fig.2